# EUROPÄISCHE PATENTSCHRIFT

(11) **EP 2 289 076 B1**
(45) Veröffentlichungstag und Bekanntmachung des Hinweises auf die Patenterteilung: **06.04.2016**
(21) Anmeldenummer: 09749927.1
(22) Anmeldetag: 22.05.2009
(51) Int. Cl.: H01C 7/12, H01C 7/10, H01C 7/105, H01C 7/102

(54) **ELEKTRISCHE BAUELEMENTANORDNUNG**
ELECTRIC COMPONENT ASSEMBLY
ENSEMBLE COMPOSANT ÉLECTRIQUE

(30) Priorität: 21.05.2008 DE 102008024479
(43) Veröffentlichungstag der Anmeldung: 02.03.2011
(73) Patentinhaber: Epcos AG, 81669 München (DE)
(72) Erfinder: FEICHTINGER, Thomas, A-8010 Graz (AT); ENGEL, Günter, A-8430 Leibnitz (AT); PECINA, Axel, A-8543 St. Martin (AT)
(74) Vertreter: Epping - Hermann - Fischer
(86) Internationale Anmeldenummer: PCT/EP2009/056247
(87) Internationale Veröffentlichungsnummer: WO 2009/141437

(56) Entgegenhaltungen:
- EP-A- 0 353 166
- DE-A1-102007 014 300
- JP-A- 11 097 215
- JP-A- 2007 288 140
- US-A1- 2001 011 766
- US-A1- 2007 075 323
- US-A1- 2007 188 963

## Beschreibung

Es wird eine Anordnung von elektrischen Bauelementen, insbesondere mit Mittel zum Schutz vor Überspannungen, beschrieben.

Aus DE 10 2007 014 300 A1 ist eine Vorrichtung mit einem Varistor und einem Licht emittierenden Bauelement bekannt.

Aus US 2007/00753 23 A1 ist eine elektrische Bauelement anordnung bekannt, aufweisend ein Halbleiterelement, das auf einem Varistorkörper montiert ist.

Eine zu lösende Aufgabe besteht darin, ein Vorrichtung bzw. Mittel anzugeben, mit der bzw. mit denen ein elektrisches Bauelement schonend vor Überspannungen geschützt werden kann.

Die Erfindung ist mit den Merkmale des Anspruchs 1 definiert.

Es wird vorgeschlagen, dass in einer elektrischen Bauelementanordnung ein Halbleiterbauelement auf einem Varistorkörper montiert ist bzw. von diesem getragen wird. Der Varistorkörper ist zum Schutz des elektrischen Bauelements mit diesem elektrisch kontaktiert. Das Halbleiterbauelement und der Varistorkörper sind vorzugsweise elektrisch parallel miteinander verschaltet.

Der Varistorkörper ist als eigenständige mechanische Einheit gebildet und als Träger des Halbleiterbauelements zu verstehen. Er kann vom Halbleiterbauelement separat hergestellt werden und weist eine Form auf, die dem Halbleiterbauelement eine Auflage- bzw. Montagefläche bietet.

Mittels des als Träger für das Halbleiterbauelement dienenden Varistorkörpers wird dem Halbleiterbauelement ein einfaches Mittel zum Schutz gegenüber Überspannungen, insbesondere gegenüber elektrostatischen Entladungen, geboten, wobei das Halbleiterbauelement vorteilhafterweise selbst zu diesem Zweck nicht weitergebildet bzw. angepasst werden muss. Der Varistorkörper kann zum Zweck des bestmöglichen Schutzes vor Überspannungen eines mit dem Varistorkörper gekoppelten Halbleiterbauelements ohne Berücksichtigung der Bauform des Halbleiterbauelements separat hergestellt bzw. entworfen werden. Die Funktion des Schutzes vor Überspannungen des Varistorkörpers darf somit ohne einer durch die Struktur des Halbleiterbauelements bedingten Einschränkung voll ausgeschöpft werden.

Gemäß einer bevorzugten Ausführungsform der Bauelementanordnung enthält der Varistorkörper ein Kompositmaterial, das zumindest aus einer Varistorkeramik und einem gut wärmeleitenden Material zusammengesetzt ist, wobei das gut wärmeleitende Material sich von der Varistorkeramik, die hauptsächlich zur nichtlinearen Widerstandsfunktion des Varistkörpers gewählt ist, unterscheidet.

Gemäß einer Ausführungsform ist die Varistorkeramik als Hauptkomponente bzw. als Matrix des Kompositmaterials und das wärmeleitende Material als Füllstoff in dieser Matrix gebildet. Ein Beispiel eines gut wärmeleitenden Füllstoffs ist ein Metall; insbesondere sind Metalle mit einer Wärmeleitfähigkeit größer 100 W/(m*K) und Edelmetalle der 2. und 3. Übergangsmetallperiode bzw. deren Legierungen zu nennen. Der Füllstoff liegt vorzugsweise als eine Verteilung von gut wärmeleitenden Partikeln im Varistorkörper vor.

Ein vorzugsweise als Füllstoff in der Varistorkeramik vorliegendes Metall hat den Vorteil, dem Varistorkörper eine höhere Wärmeleitfähigkeit zu verleihen, so dass auch Wärme vom Halbleiterbauelement über den Varistorkörper abgeleitet werden kann. Somit kann der Varistorkörper gleichzeitig zwei Funktionen aufweisen: die des Schutzes vor Überspannungen und die der Wärmeableitung.

Vorteilhaft ist eine Ausführungsform, bei der der Varistorkörper eine gut wärmeleitende Keramik enthält, die sich von der Varistorkeramik unterscheidet bzw. eine höhere Wärmeleitfähigkeit aufweist, als die Varistorkeramik. Als geeignete Keramiken haben sich zum Beispiel Aluminiumnitrid, Siliziumkarbid, Hafniumoxid und Manganoxid herausgestellt, insbesondere auch deshalb, weil sie sich mit einer bevorzugten Varistorkeramik wie zum Beispiel Zinkoxid gut versintern lassen, ohne dass sich unerwünschte kristalline Unterbrechungen im Varistorkörper ausbilden. Die zusätzliche, gut wärmeleitende Keramik kann ähnlich wie beim Metall als Füllstoff in der als Matrix ausgeführten Varistorkeramik vorliegen.

Der Varistorkörper kann als Vielschichtvaristor mit einem Stapel von Varistorkeramikschichten und zumindest bereichsweise dazwischenliegenden Innenelektrodenschichten ausgeführt sein. Es wird bevorzugt, dass der Vielschichtvaristor ein gesintertes, monolithisches Vielschichtbauelement ist. Als Varistorkeramik der einzelnen Schichten wird hauptanteilig Zinkoxid gewählt, wobei die Innenelektroden Silber, Palladium, Platin, Kupfer, Nickel oder eine Legierung dieser Materialien enthalten können.

Nach einer Ausführungsform können ein oder mehrere Schichten eines als Vielschichtvaristor ausgebildeten Varistorkörpers Zirkonoxid aufweisen. Dabei wird bevorzugt, dass zumindest die Deckschicht des Vielschichtvaristors, auf der das Halbleiterbauelement montiert ist, Zirkonoxid enthält. Dadurch können die Einflüsse von Streukapazitäten des Vielschichtvaristors auf dem Halbleiterbauelement reduziert werden. Ist der Vielschichtvaristor in einem Gehäuse integriert bzw. liegt der Vielschichtvaristor auf einer Leiterplatte, so wird bevorzugt, dass auch die Grundschicht Zirkonoxid enthält um den gleichen oben beschriebenen Effekt gegenüber dem Gehäuse bzw. der Leiterplatte zu erreichen.

Anstelle eines Vielschichtvaristors kann ein Bulkvaristor als Träger für das Halbleiterbauelement dienen. Dieser weist an seiner Außenseite gegenpolige Außenkontakte auf, ist im Innern jedoch frei von metallischen Schichten.

Gemäß einer Ausführungsform weist der Varistorkörper mehrere elektrische Anschlüsse auf, von denen zumindest ein erster elektrischer Anschluss das Halbleiterbauelement kontaktiert. Dieser elektrische Anschluss ist vorzugsweise als metallische Schicht ausgeführt. Die metallische Schicht kann auf zumindest einem Bereich der Oberseite des Varistorkörpers aufgebracht sein, beispielsweise mittels Siebdrucken. Der Bauelementanordnung wird mit einem als Schicht ausgeführten elektrischen Anschluss eine besonders kompakte Form geboten. Andere Formen von elektrischen Anschlüssen sind jedoch denkbar, wie z.B. ein Kontaktdraht.

Gemäß einer Ausführungsform der Bauelementanordnung umfassen die mehreren elektrischen Anschlüsse des Varistorkörpers zumindest einen vom ersten elektrischen Anschluss separaten, zweiten elektrischen Anschluss, der den Varistorkörper nach außen kontaktiert, welches bedeutet, dass der Varistor mit diesem zweiten elektrischen Anschluss mit einem vom Halbleiterbauelement getrennten zweiten elektrischen Potential verbunden ist. Dabei kann der zweite elektrische Anschluss mit einer Leiterbahn auf einer Leiterplatte kontaktiert sein. Es kann sich bei einem zweiten elektrischen Anschluss beispielsweise um einen Masseanschluss handeln.

Sowohl ein erster elektrischer Anschluss als auch ein zweiter elektrischer Anschluss können als metallische Schichten ausgeführt sein. Als metallische Schichten ausgeführte elektrische Anschlüsse des Varistorkörpers können zumindest eines der folgenden Materialien enthalten: Gold, Nickel, Chromium, Palladium.

Gemäß einer Ausführungsform der Bauelementanordnung ist der zweite elektrische Anschluss, der den Varistorkörper nach außen kontaktiert, auf der Unterseite des Varistorkörpers, d.h., auf der der Montagefläche des Halbleiterbauelements senkrecht gegenüberliegenden Fläche, angeordnet. Der zweite elektrische Anschluss kann beispielsweise als Bondpad ausgeführt sein. Dieser zweite elektrische Anschluss kann mit einer elektrisch leitenden Struktur einer Leiterplatte oder eines Gehäuses kontaktiert werden. Der zweite elektrische Anschluss kann darüber hinaus einen Kontaktdraht umfassen, wobei dieser beispielsweise mit einem vom elektrischen Anschluss umfassten Bondpad verbunden sein kann. Auch ist es nach einer Ausführungsform vorgesehen, dass der zweite elektrische Anschluss vom ersten elektrischen Anschluss beabstandet auf der Oberseite des Varistorkörpers angeordnet ist.

Es wird bevorzugt, dass das Halbleiterbauelement auf seiner Montageseite bzw. Unterseite eine Flipchipkontaktierung aufweist. Die Flipchipkontaktierung kann eine Anordnung bzw. ein Array von Lotkugeln auf der Unterseite des Halbleiterbauelements aufweisen.

Nach einer Ausführungsform ist es vorgesehen, dass der erste elektrische Anschluss des Varistorkörpers, der das Halbleiterbauelement kontaktiert, gleichzeitig einen Kontakt des Varistorkörpers nach außen bildet, gegebenenfalls unter Verwendung eines mit dem ersten elektrischen Anschluss verwendeten Kontaktdrahtes.

Gemäß einer Ausführungsform weist der Varistorkörper zumindest eine Innenelektrode auf, welche zur Abstimmung der Kapazität des Varistorkörpers dienen kann. Es kann sich bei der Innenelektrode um eine Masseelektrode handeln, welche Überspannungen bzw. Stoßströme durch den Varistor bzw. vom Varistorkörper ableitet. Die Innenelektrode ist mit zumindest einem elektrischen Anschluss des Varistorkörpers verbunden. Beispielsweise kann die Innenelektrode mittels zumindest einer Durchkontaktierung, auch als Via zu bezeichnen, mit dem zumindest einen elektrischen Anschluss verbunden sein.

Gemäß einer Ausführungsform sind mehrere Innenelektroden im Varistorkörper vorhanden und kontaktieren unterschiedliche elektrische Anschlüsse des Varistorkörpers. Dabei wird bevorzugt, dass sie mittels einer Varistorkeramik bzw. mittels eines Dielektrikums voneinander getrennt sind und Überlappflächen aufweisen, durch die Kapazitäten erzeugbar sind. Die Innenelektroden verlaufen gemäß einer Ausführungsform senkrecht zur Montagefläche des Halbleiterbauelements.

Gemäß der Erfindung weist der Varistorkörper zumindest einen wärmeleitenden Kanal auf, durch den Wärme vom Halbleiterbauelement ableitbar ist. Der wärmeleitende Kanal ist vorzugsweise als eine mit einem gut wärmeleitenden Material gefüllte Bohrung ausgeführt. Er kann als metallischer Pfad zwischen der Oberseite und der Unterseite des Varistorkörpers verlaufen. Dabei kann er im Wesentlichen stiftförmig ausgebildet sein. Der wärmeleitende Kanal kann jedoch auch als keramischer Pfad mit hoher Wärmeleitfähigkeit ausgeführt sein, wobei dieser keramische Pfad bzw. die Keramik des Pfads eine im Vergleich zum umliegenden Material des Varistorkörpers höhere Wärmeleitfähigkeit aufweist.

Bevorzugt wird eine Bauelementanordnung mit einem Gehäuse, das zumindest einen elektrisch leitenden Teil oder Bereich aufweist, der mit dem Varistorkörper und / oder mit dem Halbleiterbauelement kontaktiert ist. Das Gehäuse trägt den Varistorkörper, wobei das Halbleiterbauelement und der Varistorkörper mit dem elektrisch leitenden Teil des Gehäuses parallel verschaltet sind. Der elektrisch leitende Teil des Gehäuses kann als metallische Schicht, beispielsweise als Leiterbahn ausgeführt sein. Der elektrisch leitende Teil des Gehäuses enthält vorzugsweise Aluminium oder Kupfer.

Bei einer gut wärmeleitenden Ausführung des Varistorkörpers dient er als thermomechanischer Buffer zwischen dem Halbleiterbauelement und dem Gehäuse.

Gemäß einer Ausführungsform weist das Gehäuse zumindest einen wärmeleitenden Bereich auf, der thermisch mit dem Varistorkörper gekoppelt ist. Dadurch kann vom Varistorkörper aufgenommene Wärme vom Gehäuse abgeleitet werden. Dabei kann dieser Bereich ein gut wärmeleitendes Material, wie zum Beispiel eine gut wärmeleitende Keramik oder ein Metall aufweisen.

Gemäß einer günstigen Ausführungsform der Bauelementanordnung weist sie zusätzlich einen Thermistor auf, der mit dem Halbleiterbauelement verschaltet ist. In Abhängigkeit seiner Widerstands / Temperaturkennlinie trägt der Thermistor zur Regulierung des Steuerstroms des Halbleiterbauelements bei, sodass dieser schonend betrieben werden kann. Der Thermistor ist gemäß einer Ausführungsform auf dem Varistorkörper montiert, muss es aber nicht sein. Stattdessen könnte er beispielsweise neben dem Varistorkörper in einem gemeinsamen Gehäuse integriert sein. Der Thermistor kann mit einer Auswerteeinheit verbunden sein, die gemessene Werte des Thermistors verwendet um den das Halbleiterbauelement speisenden Strom zu regulieren. Die Regulierung des Steuerstroms erfolgt derart, dass die LED keinen Stoßströmen ausgesetzt wird bzw. unter möglichst konstantem Wechselstrom betrieben wird.

Das Halbleiterbauelement kann aus einer Vielzahl von Bauelementen gewählt sein. Es kann ein optoelektronisches Bauelement, wie z.B. eine LED, ein Kondensator bzw. ein Vielschichtkondensator, ein Thermistor bzw. ein Vielschichtthermistor mit PTC oder NTC Eigenschaften, eine Diode oder ein Verstärker sein. In jedem Falle ist der Varistorkörper in der Lage, das von ihm getragene Halbleiterbauelement vor Überspannungen schonend zu schützen und sogar nach einigen in diesem Dokument beschriebenen Ausführungsformen in der Lage, Wärme vom Halbleiterbauelement abzuleiten. Eine LED als Halbleiterbauelement ist zusammengesetzt vorzugsweise aus einem oder mehreren der folgenden Materialien: Galliumphosphid (GaP), Galliumnitrid (GaN), Galliumarsenphosphid (GaAsP), Aluminiumgalliumindiumphosphid (AlGaInP), Aluminiumgalliumphosphid (AlGaP), Aluminiumgalliumarsenid (AlGaAs), Indiumgalliumnitrid (InGaN), Aluminiumnitrid (AlN), Aluminiumgalliumindiumnitrid (AlGaInN), Zinnselenid (ZnSe).

Die beschriebenen Gegenstände werden anhand der folgenden Figuren und Ausführungsbeispiele näher erläutert. Dabei zeigt:
- Figur 1a: eine Draufsicht einer Bauelementanordnung mit einer ersten Anordnung von elektrischen Anschlüssen,
- Figur 1b: eine Querschnittsansicht der mit der Figur 1a gezeigten Bauelementanordnung,
- Figur 2: eine Querschnittsansicht einer Bauelementanordnung mit einem Gehäuse mit einer ersten elektrischen Verschaltung,
- Figur 3: eine Querschnittsansicht einer Bauelementanordnung mit einem Gehäuse mit einer zweiten elektrischen Verschaltung,
- Figur 4: eine Querschnittsansicht einer Bauelementanordnung mit einer ersten elektrischen Verschaltung mit einem Gehäuse,
- Figur 5a: eine Draufsicht auf eine Bauelementanordnung mit zwei separaten, oberseitigen elektrischen Anschlüssen,
- Figur 5b: eine Querschnittsansicht der mit der Figur 5a vorgestellten Bauelementanordnung,
- Figur 6: eine Querschnittsansicht einer Bauelementanordnung mit einem eine Vertiefung aufweisenden Gehäuse,
- Figur 7: eine Querschnittsansicht einer Bauelementanordnung mit einer Oberseite gemäß der Figuren 5a und 5b, wobei der Varistorkörper eine Innenelektrode und eine Durchkontaktierung aufweist,
- Figur 8: eine Querschnittsansicht einer Bauelementanordnung mit einem Varistorkörper mit einer Oberseite gemäß der Figuren 5a und 5b, wobei zusätzlich ein Halbleiterbauelement und ein Varistorkörper mit wärmeleitenden Kanälen sowie mehreren Innenelektroden gezeigt sind,
- Figur 9: eine Querschnittsansicht einer Bauelementanordnung gemäß Figur 8 mit alternativen wärmeleitenden Kanälen und Innenelektroden.

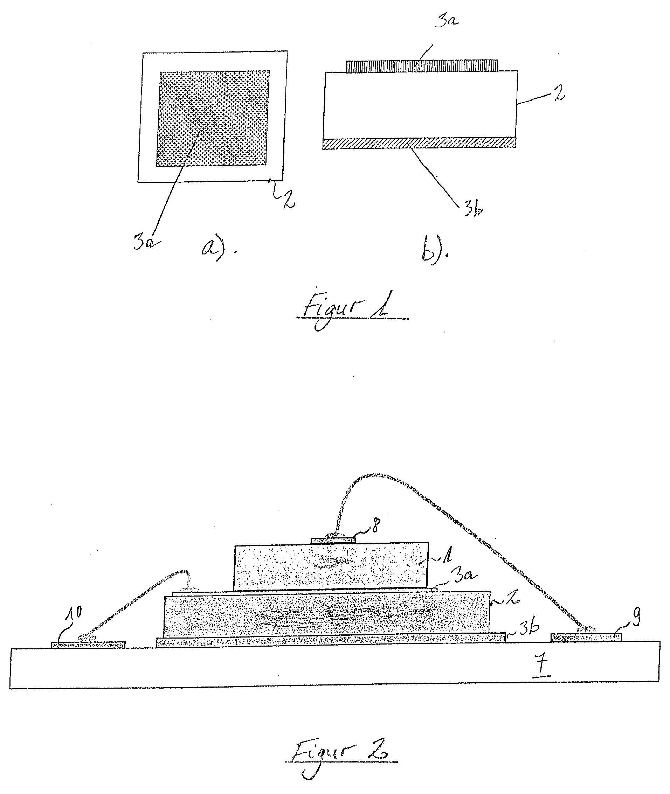

Figur 1a zeigt eine Draufsicht auf einen für ein Halbleiterbauelement, beispielsweise eine LED, als Träger dienenden Varistorkörper 2, der eine Kontaktschicht 3a auf seiner Oberseite aufweist, die zur Kontaktierung mit dem Halbeiterbauelement dient. Die Kontaktschicht 3a kann ein Anodenkontakt sein. Es wird bevorzugt, dass sie Gold enthält, vorzugsweise hauptanteilig. Der Varistorkörper 2 kann eine Dicke von zwischen 90 und 100 µm aufweisen. Als Varistorkeramik für den Varistorkörper wird vorzugsweise Zinkoxid verwendet.

Figur 1b zeigt wie der Varistorkörper 2 gemäß Figur 1a auf seiner Unterseite mit einem als Kontaktschicht ausgeführten zweiten elektrischen Anschluss 3b versehen ist, der beispielsweise als Kathoden- oder Massekontakt dienen kann. Dabei wird bevorzugt, dass es sich bei der unteren Kontaktschicht 3b um eine handelt, welche Aluminium enthält, vorzugsweise hauptanteilig. Die Kontaktschicht 3b dient vorzugsweise zur Kontaktierung des Varistorkörpers 2 nach außen, beispielsweise zur Kontaktierung mit einem Gehäuse bzw. mit dessen elektrisch leitenden Teil.

Die Keramik des Varistorkörpers besteht vorzugsweise hauptanteilig aus einem Kompositmaterial, das als Matrix eine Varistorkeramik und als Füllstoff ein Metall aufweist. Als Varistorkeramik bzw. als Matrix kann Zinkoxid bzw. die Mischung Zinkoxid - Wismut (Bi) - Antimon (Sb) oder die Mischung Zinkoxid - Präseodym (Pr) verwendet werden, wobei im Gegensatz zum nachfolgend beschriebenen Metallfüllstoff die mit dem Zinkoxid verbundenen Metalle bzw. Metalloiden Wismut, Antimon bzw. Blei nicht als von der Matrix separate Partikel vorliegen. Das als Füllstoff vorliegende Metall ist vorzugsweise gewählt aus Silber (Ag), Palladium (Pd), Platin (Pt), Wolfram (W), Legierungen dieser Elemente oder Mischungen der vorgenannten Stoffe. Als Legierungen kommen Legierungen der genannten Metalle untereinander und/oder mit anderen Elementen in Betracht; beispielsweise sind Silber-Palladium-Legierungen zu nennen. Als Füllstoff sind vorzugsweise stochastisch in der Varistorkeramik verteilte Metallpartikel zu verstehen, die jeweils aus Metallverbindungen bestehen können. Eine möglichst homogene Verteilung von Partikeln ist bevorzugt.

Figur 2 zeigt eine Querschnittsansicht einer optoelektronischen Bauelementanordnung, bei der als Halbleiterbauelement eine LED 1 auf einem Varistorkörper 2 montiert ist. Die Bauelementanordnung umfasst ein Gehäuse 7, dessen einen Teil dargestellt ist. Der Varistorkörper 2 ist auf dem Gehäuse 7 montiert bzw. wird von diesem getragen. Der Varistorkörper 2 ist über einen als Schicht, vorzugsweise enthaltend Aluminium, ausgeführten Masseanschluss 3b mit einem elektrisch leitenden Teil des Gehäuses 7 kontaktiert. Oberseitig ist der Varistorkörper 2 mittels eines als Schicht ausgeführten Anodenkontakts 3a bzw. über einen ersten elektrischen Anschluss mit der LED 1 kontaktiert. Die LED ist oberseitig mit einem als Schicht bzw. Bondpad ausgeführten Kathodenkontakt 8 versehen. Der Kathodenkontakt 8 weist einen mit dem Bondpad verbundenen Kontaktdraht auf, der eine elektrische Verbindung zum entsprechenden Kathodenkontakt 9 des Gehäuses 7 herstellt. Der Kathodenkontakt 9 des Gehäuses kann als Leiterbahn ausgeführt sein. Auch weist das Gehäuse einen beispielsweise als Leiterbahn ausgeführten Anodenkontakt 10 auf, der mittels eines Kontaktdrahtes mit dem Anodenkontakt 3a zwischen dem Varistorkörper 2 und der LED 1 in elektrisch leitender Verbindung gebracht ist. Der erste elektrische Anschluss 3a weist eine vom Halbleiterbauelement freigelassene Fläche auf, die Platz schafft um auf derselben Oberseite des Varistorkörpers diesen nach außen zu kontaktieren.

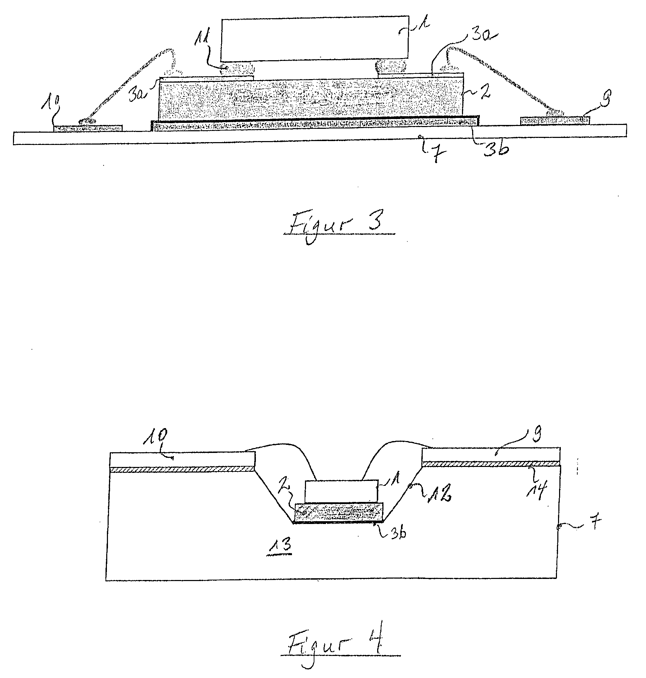

Figur 3 zeigt eine Querschnittsansicht einer optoelektronischen Bauelementanordnung, bei der als Halbleiterbauelement eine LED 1 auf einem Varistorkörper 2 montiert ist, wobei die LED auf ihrer Unterseite eine Flipchipkontaktierung 11 aufweist. Oberseitig weist der Varistorkörper 2 zwei voneinander beabstandete elektrische Anschlüsse 3a und 3b als Anodenkontakt und als Kathodenkontakt auf. Der Varistorkörper 2 ist mittels dieser jeweils als metallische Schichten ausgeführten Anschlüsse 3a und 3b mit der Flipchipkontaktierung 11 der LED 1 kontaktiert. Die Bauelementanordnung umfasst ein Gehäuse 7, dessen einen Teil in der Figur dargestellt ist, wobei die elektrischen Anschlüsse 3a des Varistorkörpers 2 mit entsprechenden Kontakten 9 und 10 des Gehäuses 7 in Verbindung gebracht sind. Der Varistorkörper 2 ist über einen als Schicht, vorzugsweise enthaltend Aluminium, ausgeführten Masseanschluss 3b als zweiter elektrischer Anschluss mit einem elektrisch leitenden Teil des Gehäuses 7 kontaktiert.

Figur 4 zeigt eine Querschnittsansicht einer Bauelementanordnung, bei der eine LED 1 auf einem Varistorkörper 2 montiert ist, wobei ein nicht dargestellter Anodenanschluss und ein Kathodenanschluss auf der Unterseite der LED diese mit dem Varistorkörper 2 kontaktieren. Der Varistorkörper wird seinerseits von einem Gehäuse 7 getragen, der eine Einbuchtung 12 oder Grube aufweist, in die der Varistorkörper 2 mit der von ihm getragenen LED 1 angeordnet sein kann. Die LED und der Varistorkörper sind demnach im Gehäuse integriert. Die LED weist oberseitig zwei elektrische Anschlüsse auf, die jeweils einen Kontaktdraht aufweisen. Die Kontaktdrähte kontaktieren jeweils einen entsprechenden elektrisch leitenden Anodenteil 9 bzw. Kathodenteil 10 des Gehäuses. Der Varistorkörper 2 ist auf seiner Unterseite mit einem Masseanschluss 3b versehen, der einen vom Anodenteil 9 bzw. Kathodenteil 10 des Gehäuses isolierten Massekontakt 13 des Gehäuses 7 kontaktiert. Die Isolierung erfolgt über eine Isolierschicht 14, die als Bestandteil des Gehäuses ausgeführt sein kann.

In dem Falle, dass als Halbleiterbauelement eine LED vom Varistorkörper 2 getragen wird, ist die der LED zugewandte Oberfläche des Gehäuses 7, insbesondere die Innenfläche der Vertiefung 12, vorzugsweise mit einer reflektiven Schicht versehen, die die gesamte Auskopplung des von der LED emittierten Lichts verbessert. Zum selben Zweck kann eine freiliegende Oberfläche des Varistorkörpers ebenfalls mit einer reflektiven Schicht versehen sein.

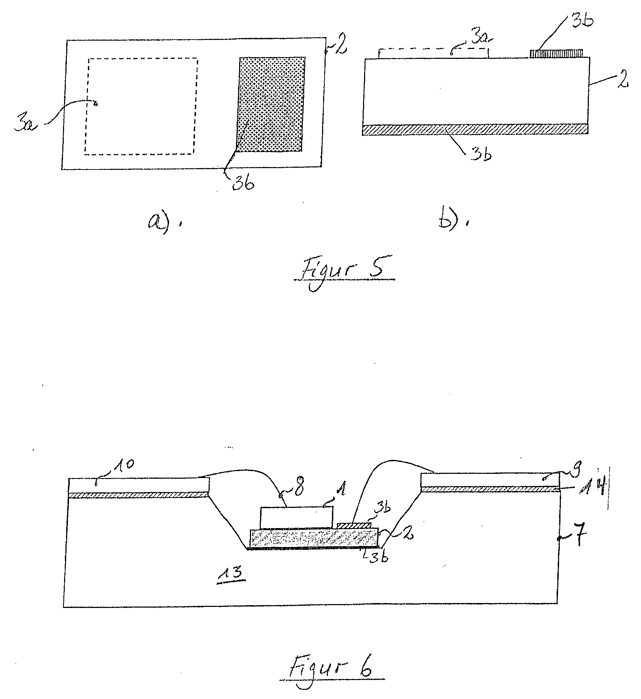

Figur 5a zeigt eine Draufsicht auf eine Bauelementanordnung, bei der auf der Oberseite des Varistorkörpers 2 zwei voneinander getrennte elektrische Anschlüsse 3a und 3b angeordnet bzw. jeweils als eine elektrisch leitende Schicht aufgebracht sind. Der erste elektrische Anschluss 3a, der als gestrichelter Rahmen gezeigt ist, kontaktiert ein auf dem Varistorkörper 2 montiertes Halbleiterbauelement 1, wobei dieses Halbleiterbauelement seinerseits einen gegenüber dem elektrischen Anschluss 3a gegenpoligen elektrischen Anschluss aufweist, beispielsweise auf seiner Oberseite (siehe hierzu beispielsweise auch die Figur 6). Separat von und neben diesem ersten elektrischen Anschluss 3a ist ebenfalls auf der Oberseite des Varistorkörpers 2 ein zweiter elektrischer Anschluss 3b angeordnet, der den Varistorkörper 2 nach außen, zum Beispiel mit einem elektrisch leitenden Teil 9 des Gehäuses, kontaktiert. Der zweite elektrische Anschluss 3b weist vorzugsweise neben der auf dem Varistorkörper aufgebrachten metallischen Schicht einen Kontaktdraht auf, der den Varistor mit dem Gehäuse 7 elektrisch kontaktiert.

Figur 5b zeigt eine Querschnittsansicht der Bauelementanordnung gemäß Figur 5a, insbesondere noch zusätzlich den Masseanschluss 3b auf der Unterseite der Bauelementanordnung.

Figur 6 zeigt eine optoelektronische Bauelementanordnung, bei der ein ein Halbleiterbauelement 1 wie z.B. eine LED tragender Varistorkörper 2 in der Einbuchtung bzw. Vertiefung 12 eines Gehäuses 7 integriert ist. Die elektrischen Anschlüsse des Varistorkörpers 2 sind gemäß der Beschreibung zu den Figuren 5a und 5b ausgebildet. Die Einbuchtung 12 weist vorzugsweise auf ihrer dem Licht der LED exponierten Oberfläche eine reflektive Beschichtung auf. Dadurch kann die gesamte Lichtauskopplung von der Bauelementanordnung vergrößert werden. Der Masseanschluss 3b des Varistorkörpers ist mit einem entsprechenden Masseanschluss 13 des Gehäuses 7, der vom Kathodenanschluss 9 und vom Anodenanschluss 10 mittels der Isolierschicht 14 elektrisch entkoppelt ist, kontaktiert. Der Bereich des Gehäuses, der die Einbuchtung 12 aufweist, kann der Bereich seines Masseanschlusses 13 sein. Dieser Bereich könnte beispielsweise aus einem Metall wie z.B. Kupfer oder Aluminium bestehen. Es wird insbesondere ein Metall bevorzugt, dass mit geringem Widerstand elektrisch leitend ist und eine hohe Reflektivität für eine verbesserte Lichtauskopplung aufweist.

Vorzugsweise ist der Varistorkörper 2 mit einem gut wärmeleitenden Bereich des Gehäuses mechanisch verbunden, in jedem Fall jedoch thermisch mit ihm gekoppelt, damit das Gehäuse vom Varistorkörper aufgenommene Wärme, welche vom Varistorkörper 2 und / oder vom Halbleiterelement 1 stammt bzw. von diesen abgegeben wird, weiter nach außen ableiten kann.

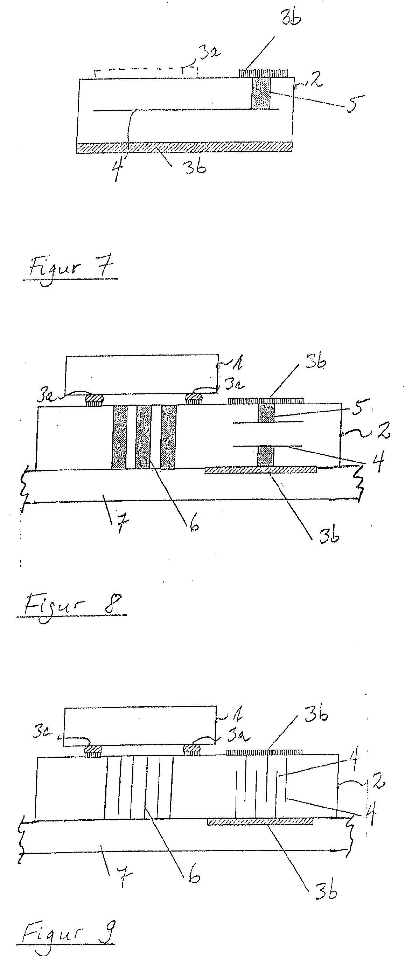

Figur 7 zeigt eine Querschnittsansicht einer Bauelementanordnung, bei der der Varistorkörper 2 eine Innenelektrode 4 aufweist, die im Innern des Varistorkörpers parallel zur Auflagefläche des Halbleiterbauelements verläuft und mit einer Durchkontaktierung 5 verbunden ist. Die Ränder der Innenelektrode 4 verbleiben im Innern des Varistorkörpers; sie reichen nicht bis an seinen Rand. Abgesehen von ihrer Kontaktierung mit der Durchkontaktierung 5 ist die Innenelektrode als "schwebend" zu betrachten. Die Durchkontaktierung oder das Via 5 verbindet die Innenelektrode 4 elektrisch mit dem zweiten elektrischen Anschluss 3b auf der Oberseite des Varistorkörpers. Die Durchkontaktierung kann durch eine mit einem Metall gefüllte Bohrung im Varistorkörper geschaffen sein. Sie weist vorzugsweise ein mit dem zweiten elektrischen Anschluss 3b sowie mit der Innenelektrode 4 gemeinsames Material auf. Auf der Unterseite des Varistorkörpers 2 ist ein Masseanschluss 3b gezeigt.

Der Varistorkörper 2 weist einen varistorkeramischen Schichtstapel auf, wobei die Innenelektrode zwischen zwei benachbarten Schichten des Stapels angeordnet ist.

Bei der Bauelementanordnung gemäß Figur 8 weist der Varistorkörper 2 mehrere wärmeleitende Kanäle 6 auf, die auch als thermische Vias bezeichnet werden können. Sie verlaufen nebeneinander senkrecht zur Auflagefläche des Halbleiterbauelements 1 auf dem Varistorkörper 2 und reichen von dort bis zur Unterseite des Varistorkörpers bzw. bis zu dessen Grundfläche. Die thermischen Vias können als mit einem gut wärmeleitenden Material gefüllte senkrechte Bohrungen des Varistorkörpers ausgeführt sein. Die thermischen Vias 6 können jeweils Metalle aufweisen. Nach einer Ausführungsform weisen sie jedoch eine gut wärmeleitende Keramik auf, insbesondere eine Keramik, welche eine höhere Wärmeleitfähigkeit aufweist, als die des umliegenden Materials. Sie können ebenfalls eine Mischung aus einem Metall und einer gut wärmeleitenden Keramik aufweisen. Anstelle von mehreren thermischen Vias 6 könnte auch ein einziges thermisches Via 6 sich von der Oberseite bis zur Unterseite des Varistorkörpers 2 erstrecken.

Thermische Vias wie sie mit dieser Figur gezeigt werden können bei allen in diesem Dokument beschriebenen Ausführungsformen der Bauelementanordnung im Varistorkörper vorhanden sein.

Figur 8 zeigt außerdem, dass lateral neben den thermischen Vias 6 (bezogen auf die Auflagefläche des Halbleiterbauelements) mehrere übereinander angeordnete Innenelektroden 4 im Varistorkörper vorhanden sind, die jeweils mit einer Durchkontaktierung 5 verbunden sind. Dabei ist eine erste Innenelektrode 4 mittels einer Durchkontaktierung 5 mit dem Masseanschluss 3b auf der Unterseite des Varistorkörpers 2 elektrisch verbunden und die zweite Innenelektrode mittels einer weiteren Durchkontaktierung 5 mit einem den Varistorkörper nach außen kontaktierenden elektrischen Anschluss 3b kontaktiert, der beispielsweise auf der Oberseite des Varistorkörpers angeordnet sein kann. Zwischen den Innenelektroden ist Varistormaterial vorhanden. Die Innenelektroden verlaufen parallel zur Montagefläche des Halbleiterbauelements 1 auf dem Varistorkörper; die Durchkontaktierungen 5 senkrecht zu den Innenelektroden. Der Varistorkörper 2 weist hier ebenfalls einen varistorkeramischen Schichtstapel auf, wobei zwischen zwei benachbarten Schichten eine zumindest eine Innenelektrode angeordnet ist.

Figur 9 zeigt einen als auf seiner Längsseite liegenden Vielschichtvaristorkörper 2, wobei zwischen benachbarten varistorkeramischen Schichten Metallstrukturen vorhanden sind. Unterhalb des auf der oberen Längsseite des Vielschichtvaristorkörpers montierten Halbleiterbauelements 1 verlaufen dünne metallische Schichten, welche die Wärme vom Halbleiterbauelement zum Gehäuse 7 ableiten. Mit den zweiten elektrischen Anschlüssen 3b des Vielschichtvaristorkörpers 2, wobei einer dieser Anschlüsse ein Masseanschluss ist, sind Innenelektroden 4 verbunden, wobei jeweils ein erster Satz von Innenelektroden mit dem Masseanschluss und ein zweiter Satz von Innenelektroden mit dem weiteren elektrischen Anschluss 3b kontaktiert sind. In Stapelrichtung benachbart jeweils eine Innenelektrode 4 des ersten Satzes eine Innenelektrode 4 des zweiten Satzes. Die Innenelektroden weisen in Stapelrichtung des Vielschichtvaristorkörpers überlappende Flächen auf (in orthogonaler Projektion). Zwischen diesen sich überlappenden Flächen der Innenelektroden lassen sich Kapazitäten mit der Varistorkeramik als Dielektrikum erzeugen. Die wärmeleitenden, metallischen Strukturen 6 unterhalb des Halbleiterbauelements sowie die Innenelektroden 4 laufen senkrecht zur Auflagefläche des Halbleiterbauelements.

Besonders vorteilhaft ist es bei einer Ausführungsform gemäß Figur 9, dass sowohl die wärmeleitenden Bahnen 6 als auch die Innenelektroden 6 in gleicher Weise auf varistorkeramische Schichten gedruckt werden können, welches den Herstellungsaufwand der Bauelementanordnung deutlich reduziert.

Im Rahmen dieses Dokuments beschriebene Ausführungsbeispiele sollen derart verstanden werden, dass jeder Varistorkörper ein Kompositmaterial aus einer Varistorkeramik als Hauptkomponente bzw. als Matrix und einem gut wärmeleitenden Material als Füllstoff enthalten kann. Bei einem Vielschichtvaristor können einzelne oder alle varistorkeramischen Schichten eine solche Zusammensetzung aufweisen.

### Bezugszeichenliste

- 1: Halbleiterbauelement
- 2: Varistorkörper
- 3a: elektrischer Kontakt des Varistorkörpers zur LED
- 3b: elektrischer Kontakt des Varistorkörpers nach außen
- 4: Innenelektrode des Varistorkörpers
- 5: Durchkontaktierung des Varistorkörpers
- 6: wärmeleitender Kanal des Varistorkörpers
- 7: Gehäuse
- 8: erster elektrischer Kontakt der LED
- 9: erster elektrischer Teil des Gehäuses
- 10: zweiter elektrisch leitender Teil des Gehäuses
- 11: Flipchipkontaktierung der LED
- 12: Einbuchtung des Gehäuses
- 13: Masseanschluss des Gehäuses
- 14: Isolierschicht des Gehäuses

## Patentansprüche

1. Elektrische Bauelementanordnung, aufweisend zumindest ein Halbleiterbauelement (1), das auf einer Auflagefläche eines Varistorkörpers (2) montiert ist,
wobei der Varistorkörper mit dem Halbleiterbauelement zu dessen Schutz vor elektrostatischen Entladungen kontaktiert ist,
wobei der Varistorkörper ein Kompositmaterial enthält, das als Matrix eine Varistorkeramik und als Füllstoff ein sich von der Varistorkeramik unterscheidendes, wärmeleitendes Material aufweist, und **dadurch gekennzeichnet,**
**daß** der Varistorkörper (2) zumindest einen wärmeleitenden Kanal (6) aufweist, durch den Wärme vom Halbleiterbauelement (1) ableitbar ist, und wobei der Wärmeleitende Kanal (6), insbesondere senkrecht, von der Auflagefläche zur Unterseite des Varistorkörpers (2) verläuft.

2. Bauelementanordnung nach Anspruch 1, bei der der Füllstoff gewählt ist aus zumindest einem Material der Auswahl: Metall, wärmeleitende Keramik.

3. Bauelementanordnung nach einem der vorhergehenden Ansprüche, bei der der Varistorkörper (2) mehrere elektrische Anschlüsse (3a, 3b) aufweist, von denen zumindest ein erster elektrischer Anschluss (3a) das Halbleiterbauelement (1) kontaktiert.

4. Bauelementanordnung nach Anspruch 3, bei der die mehreren elektrischen Anschlüsse (3a, 3b) des Varistorkörpers (2) einen vom ersten elektrischen Anschluss separaten, zweiten elektrischen Anschluss (3b) umfassen, der den Varistorkörper nach außen kontaktiert.

5. Bauelementanordnung nach Anspruch 4, bei der der zweite elektrische Anschluss (3b) auf der Unterseite des Varistorkörpers (2) angeordnet ist.

6. Bauelementanordnung nach einem der vorhergehenden Ansprüche, bei der das Halbleiterbauelement (1) mit dem Varistorkörper (2) flipchipkontaktiert ist.

7. Bauelementanordnung nach einem der Ansprüche 3 bis 6, bei der der Varistorkörper (2) zumindest eine Innenelektrode (4) aufweist, die mit einem elektrischen Anschluss (3a, 3b) verbunden ist.

8. Bauelementanordnung nach Anspruch 7, bei der die Innenelektrode (4) mittels zumindest einer Durchkontaktierung (5) mit dem elektrischen Anschluss (3a, 3b) verbunden ist.

9. Bauelementanordnung nach einem der Ansprüche 7 oder 8, bei der mehrere Innenelektroden (4) unterschiedliche elektrische Anschlüsse (3a, 3b) des Varistorkörpers (2) kontaktieren und gemeinsame Überlappflächen aufweisen.

10. Bauelementanordnung nach einem der vorhergehenden Ansprüche, bei der der wärmeleitende Kanal (6) ein Material enthält, das gewählt ist aus zumindest einem Material der Auswahl: Metall, wärmeleitende Keramik.

11. Bauelementanordnung nach einem der vorhergehenden Ansprüche, bei der der Varistorkörper (2) mit dem auf ihm montierten Halbleiterbauelement (1) in einem Gehäuse (7) integriert ist, wobei das Gehäuse ein mit dem Varistorkörper verbundenen, wärmeleitenden Bereich aufweist, der mit dem Varistorkörper thermisch gekoppelt ist.

12. Bauelementanordnung nach einem der vorhergehenden Ansprüche, bei der Varistorkörper (2) und das Halbleiterbauelement (1) parallel verschaltet sind.

13. Bauelementanordnung nach einem der vorhergehenden Ansprüche, bei dem das Halbleiterbauelement (1) gewählt ist aus einer Menge von Bauelementen enthaltend: LED, Kondensator, Thermistor, Diode, Verstärker, Transformator.

14. Bauelementanordnung nach einem der vorhergehenden Ansprüche, zusätzlich aufweisend einen Thermistor, der in Abhängigkeit seiner Widerstands / Temperaturkennlinie zur Regulierung des Steuerstroms des Halbleiterbauelements (1) beiträgt.

## Claims

1. Electric component arrangement, comprising at least one semiconductor component (1) mounted on a bearing area of a varistor body (2),
wherein the varistor body is contact-connected to the semiconductor component for the protection thereof against electrostatic discharges,
wherein the varistor body contains a composite material comprising as matrix a varistor ceramic and as filler a thermally conductive material that differs from the varistor ceramic, and **characterized in that** the varistor body (2) comprises at least one thermally conductive channel (6) through which heat from the semiconductor component (1) can be dissipated, and wherein the thermally conductive channel (6) runs, in particular perpendicularly, from the bearing area to the underside of the varistor body (2).

2. Component arrangement according to Claim 1, wherein the filler is chosen from at least one material of the selection: metal, thermally conductive ceramic.

3. Component arrangement according to either of the preceding claims, wherein the varistor body (2) has a plurality of electrical terminals (3a, 3b), at least one first electrical terminal (3a) of which makes contact with the semiconductor component (1).

4. Component arrangement according to Claim 3, wherein the plurality of electrical terminals (3a, 3b) of the varistor body (2) comprise a second electrical terminal (3b), which is separate from the first electrical terminal and which makes contact with the varistor body toward the outside.

5. Component arrangement according to Claim 4, wherein the second electrical terminal (3b) is arranged on the underside of the varistor body (2).

6. Component arrangement according to any of the preceding claims, wherein the semiconductor component (1) is flip-chip contact-connected to the varistor body (2).

7. Component arrangement according to any of Claims 3 to 6, wherein the varistor body (2) has at least one internal electrode (4) connected to an electrical terminal (3a, 3b).

8. Component arrangement according to Claim 7, wherein the internal electrode (4) is connected to the electrical terminal (3a, 3b) by means of at least one plated-through hole (5).

9. Component arrangement according to either of Claims 7 and 8, wherein a plurality of internal electrodes (4) make contact with different electrical terminals (3a, 3b) of the varistor body (2) and have common overlap areas.

10. Component arrangement according to any of the preceding claims, wherein the thermally conductive channel (6) contains a material chosen from at least one material of the selection: metal, thermally conductive ceramic.

11. Component arrangement according to any of the preceding claims, wherein the varistor body (2) with the semiconductor component (1) mounted on it is integrated in a housing (7), wherein the housing has a thermally conductive region which is connected to the varistor body and which is thermally coupled to the varistor body.

12. Component arrangement according to any of the preceding claims, wherein the varistor body (2) and the semiconductor component (1) are connected in parallel.

13. Component arrangement according to any of the preceding claims, wherein the semiconductor component (1) is chosen from a set of components containing: LED, capacitor, thermistor, diode, amplifier, transformer.

14. Component arrangement according to any of the preceding claims, additionally comprising a thermistor which contributes, in a manner dependent on its resistance/temperature characteristic curve, to the regulation of the control current of the semiconductor component (1).

## Revendications

1. Ensemble à composants électriques, comprenant au moins un composant à semi-conducteur (1) qui est monté sur une surface d'installation d'un corps de varistance (2),
dans lequel le corps de varistance est mis en contact avec l'élément à semi-conducteur afin de protéger ce dernier contre des décharges électrostatiques,
dans lequel le corps de varistance contient un matériau composite présentant, en tant que matrice, une céramique de varistance et, en tant que matériau de charge, un matériau thermiquement conducteur différent de la céramique de la varistance, et
**caractérisé en ce que** le corps de varistance (2) comprend au moins un canal thermiquement conducteur (6) par l'intermédiaire duquel la chaleur provenant du composant à semi-conducteur (1) peut être éliminée, et dans lequel le canal thermiquement conducteur (6) s'étend notamment perpendiculairement depuis la surface d'installation jusqu'à la face inférieure du corps de varistance (2).

2. Ensemble à composants selon la revendication 1, dans lequel le matériau de charge est sélectionné parmi au moins un matériau du groupe constitué d'un métal et d'une céramique thermiquement conductrice.

3. Ensemble à composants selon l'une quelconque des revendications précédentes, dans lequel le corps de varistance (2) comprend de multiples bornes électriques (3a, 3b) parmi lesquelles au moins une première borne électrique (3a) est en contact avec le composant à semi-conducteur (1).

4. Ensemble à composants selon la revendication 3, dans lequel les multiples bornes électriques (3a, 3b) du corps de varistance (2) comprennent un seconde borne électrique (3b) séparée de la première borne électrique, qui est en contact vers l'extérieur avec le corps de varistance.

5. Ensemble à composants selon la revendication 4, dans lequel la seconde borne électrique (3b) est disposée sur la face inférieure du corps de varistance (2).

6. Ensemble à composants selon l'une quelconque des revendications précédentes, dans lequel le composant à semi-conducteur (1) est connecté au corps de varistance (2) par la technique des puces à bosses.

7. Ensemble à composants selon l'une quelconque des revendications 3 à 6, dans lequel le corps de varistance (2) comprend au moins une électrode interne (4) qui est connectée à une borne électrique (3a, 3b).

8. Ensemble à composants selon la revendication 7, dans lequel l'électrode interne (4) est connectée au moyen d'au moins un contact traversant (5) à la borne électrique (3a, 3b).

9. Ensemble à composants selon l'une quelconque des revendications 7 ou 8, dans lequel les multiples électrodes internes (4) sont en contact avec des bornes électriques différentes (3a, 3b) du corps de varistance (2) et comprennent des surfaces de chevauchement communes.

10. Ensemble à composants selon l'une quelconque des revendications précédentes, dans lequel le canal thermiquement conducteur (6) contient un matériau qui est sélectionné parmi au moins l'un des matériaux du groupe constitué d'un métal et d'une céramique thermiquement conductrice.

11. Ensemble à composants selon l'une quelconque des revendications précédentes, dans lequel le corps de varistance (2) est intégré au composant à semi-conducteur (1) monté sur celui-ci dans un boîtier (7), dans lequel le boîtier comprend une région thermiquement conductrice connectée au corps de varistance, qui est thermiquement couplée au corps de varistance.

12. Ensemble à composants selon l'une quelconque des revendications précédentes, dans lequel le corps de varistance (2) et le composant à semi-conducteur (1) sont connectés en parallèle.

13. Ensemble à composants selon l'une quelconque des revendications précédentes, dans lequel le composant à semi-conducteur (1) est choisi dans le groupe constitué d'une certaine quantité de composants comportant : une LED, un condensateur, une thermistance, une diode, un amplificateur, un transformateur.

14. Ensemble à composants selon l'une quelconque des revendications précédentes, comprenant en outre une thermistance qui participe à la régulation du courant de commande du composant à semi-conducteur (1) en fonction de sa courbe caractéristique de résistance/température.
